# EUROPÄISCHE PATENTSCHRIFT

(11) **EP 0 595 278 B1**
(45) Veröffentlichungstag und Bekanntmachung des Hinweises auf die Patenterteilung: **04.08.1999**
(21) Anmeldenummer: 93117370.2
(22) Anmeldetag: 27.10.1993
(51) Int. Cl.: H04B 1/30, H03D 1/22

(54) **Homodynempfänger und Verfahren zur Korrektur des konvertierten Empfangssignals**
Homodyne receiver and method for correcting the converted signals
Récepteur homodyne et procédé pour corriger les signaux convertis

(30) Priorität: 29.10.1992 DE 4236547
(43) Veröffentlichungstag der Anmeldung: 04.05.1994
(73) Patentinhaber: HAGENUK GMBH, D-24118 Kiel (DE)
(72) Erfinder: Behrent, Hermann, D-22958 Kuddewörde (DE)
(74) Vertreter: Hansmann, Dierk, Dipl.-Ing.

(56) Entgegenhaltungen:
- EP-A- 0 490 275
- 40TH IEEE VEHICULAR TECHNOLOGY CONFERENCE Mai 1990 , ORLANDO,FL,US Seiten 668 - 674 XP204191 SCHULTES ET AL 'A New Incoherent Direct Conversion Receiver'

## Beschreibung

Die Erfindung betrifft einen Homodynempfänger (Direct Conversion-Empfänger), insbesondere für winkelmodulierte Trägersignale, speziell auch solchen, bei denen das konvertierte Signal(ZF) einen Gleichspannungsanteil (DC-Anteil) aufweist, und ein Verfahren zur Korrektur des konvertierten Empfangssignals.

Direct Conversion-Empfänger sind zum Beispiel aus DE 29 02 952 C2 bekannt. Hiernach genügt es theoretisch, das Empfangssignal gegebenenfalls nach einer Vorverstärkung mit der von einem lokalen Oszillator erzeugten Trägerfrequenz zu mischen und dabei entstehende hohe Summenfrequenzen mit einem Tiefpaß abzutrennen. Das gefilterte Signal soll dem demodulierten Signal entsprechen. Die Frequenz des lokalen Oszillators soll in einer Phasenregelschleife (Phase-Locked Loop; PLL) auf die Trägerfrequenz eingestellt werden. Die PLL zur Frequenz- und Phasenregelung ist erforderlich, weil bei gebräuchlichen Referenzsignalquellen grundsätzlich eine mehr oder minder große Frequenzabweichung zur Trägerfrequenz besteht. Die Synchronisation des lokalen Oszillators mit der Trägerfrequenz bzw. Frequenz des sendenden Oszillators muß also erst erzwungen werden. Hierzu wird der empfangene Träger als Referenzsignal für die Regelung herangezogen. Das zur Regelung des lokalen Oszillators verwendete Fehlersignal kann, wenn das empfangene Signal sehr schwach ist und auf dem Übertragungsweg gestört wird, nicht von dem bei der direkten Umsetzung des modulierten Trägersignals entstehenden DC-offset unterschieden werden. Die PLL-Regelung versagt dann.

Nach GB 2 192 506 wird das winkelmodulierte Eingangssignal in zwei Zweige aufgeteilt und zu den beiden Zweigen die Frequenz eines lokalen Oszillators zugemischt, wobei für einen Zweig eine Phasenverschiebung der zugemischten Frequenz von 90° eingestellt ist. Das Mischsignal in dem Zweig ohne Phasenverschiebung wird als in-phase Signal (I), das Mischsignal in dem Zweig mit Phasenverschiebung wird als Quadratursignal (Q) bezeichnet. Es sind Tiefpaßfilter und Analog-Digitalwandler vorgesehen. Die digitalen Signale aus beiden Zweigen werden einem digitalen Signalprozessor (DSP) zugeleitet. In diesem wird aus dem I- und Q-Signalen das demodulierte Signal berechnet. Auch die I- und Q-Signale weisen einen von der direkten Umsetzung des modulierten Trägersignals stammenden DC-offset auf. Weitere ungewollte DC-offsets können durch das Übersprechen des lokalen Oszillators auf die Signaleingänge des Mischers und durch die relative Phasenlage des lokalen Oszillators zum Träger des empfangenen Signals entstehen. Gegebenenfalls eingefügte Verstärker führen ebenfalls zu einem weiteren DC-offset. Die Gesamtheit der DC-offset-Spannungen (folgend aus Betriebstemperatur, der Alterung der Bauteile, Phasenlage, Übersprechen, Verstärker-offset) kann bei sehr kleinen Eingangssignalen etliche zehntausendmal größer sein als das Nutzsignal, so daß ein AD-Wandler einen großen Dynamikbereich haben muß, um das Nutzsignal noch auflösen zu können. Damit ist die Verwendung kostengünstiger und schneller AD-Wandler bei der erforderlichen Auflösung des Nutzsignals weitestgehend ausgeschlossen.

Für Heterodynempfänger wurde die Verwendung eines Bandpasses für das ZF-Signal zum Beispiel in W088/10033 vorgeschlagen. Damit wird ein DC-offset abgetrennt. Mit dem DC-offset werden aber auch DC-Anteile des konvertierten Signals durch die Bandpässe abgetrennt. Bei vielen Modulationsarten enthält der (kurzzeitige) DC-Anteil des konvertierten Signals Informationen über das modulierende Signal. Mit der Abtrennung des DC-Anteils des konvertierten Signals gehen demzufolge auch Informationen des modulierenden Signals verloren, woraus eine erhebliche Störung des demodulierten Signals folgt. Insbesondere wird der Klirrfaktor erhöht.

Weitere wesentliche Anteile, die zu störenden Verzerrungen der orthogonalen Quadratursignale im Basisband beim Homodynempfänger führen, sind neben dem DC-offset der Amplitudenunterschied und der Phasenfehler zwischen dem I- und Q-Zweig. Der Amplitudenunterschied entsteht bei der Aufteilung des Eingangssignals und die ungleiche Verstärkung in den Signalzweigen. Der Phasenfehler entsteht durch die Ablage der beiden LO-Signale an den zwei Mischern von den nominell erforderlichen 90° und die unterschiedlichen Phasenbeläge in den zwei Signalzweigen.

Ein Verfahren zur Korrektur von Amplituden- und Phasenfehlern in den I- und Q-Signalen wurde bereits in der DE 39 38 671 A1 beschrieben. Dort wurden die I- und Q-Signale in neue Signale umgerechnet, die einen geringeren Amplituden- und Phasenfehler aufweisen. Es tritt jedoch eine Frequenzverdopplung ein, die bei der Weiterverarbeitung höhere Abtastfrequenzen erforderlich macht. Dies ist mit erhöhtem Aufwand verbunden. Außerdem können bei begrenzt zulässigem Klirrfaktor und bei Vermeidung von zusätzlichen Tönen nur sehr kleine Fehler der I- und Q-Signale zugelassen werden, die nur mit aufwendigen Bauteilen in der HF-Baugruppe zu erreichen sind. Das Verfahren führt daher nicht zu einer weitgehenden Fehlerkorrektur EP 0 343 273 A1 betrifft eine Korrekturschaltung für ein digitales Quadratur-Signalpaar. Es werden Offset-Fehler, Amplitudenfehler und Phasenfehler korrigiert. Hierbei wird davon ausgegangen, daß das verzerrungsfreie Signal ohne die genannten Fehler einen Kreis in Mittelpunktslage darstellt. Die Verzerrungen führen zur Verschiebung des Kreises aus dem Ursprung (Offset), zur Abflachung des Kreises zur Ellipse (Amplitudenfehler) und zur Schwerung bzw. Drehung der Ellipse, wobei von einer Polarkoordinatendarstellung von In-Phase- und Quadratursignal ausgegangen wurde. Aus den Extremwerten der Ellipse werden Regelgrößen zur Korrektur von Offset, Amplitudenfehler und Phasenfehler abgeleitet. Abgesehen von den bekannten Anfälligkeiten derartiger Regelungen, wie Auftreten von Instabilitäten oder gar Resonanzen kann die vorgeschlagene Regelung nur dann vorgenommen werden, wenn das Signal weitestgehend ungestört ist. Nur dann beschreiben in der Polarkoordinatendarstellung die In-Phase- und Quadratursignale eine für die Regelung ausreichend genaue Ellipse. Bei praktisch vorliegenden Signalen sind aber zusätzlich zu den genannten Fehlergrößen bzw. Verzerrungen noch Störungen wie Signalrauschen überlagert. Die In-Phase- und Quadratursignale beschreiben dann in der Polarkoordinatendarstellung eine Punktwolke von grob gesehen elliptischer Form. In diesem Fall erscheint die vorgeschlagene Regelung nicht ausreichend funktionsfähig. Außerdem muß die Ortskurve ausreichend oft durchlaufen sein, so daß die einzelnen Werte sich auf der anzunehmenden Ellipse gleich verteilt einstellen. Dies gilt insbesondere, wenn, wie vorgesehen, eine Mittelung der Extremwerte erfolgen soll. Es wird darüberhinaus eine bevorzugte Schaltung für eine Extremwertbestimmung vorgeschlagen, bei der die Abklingzeit sehr viel größer als die Anstiegszeit ist. Damit werden am Rand der Punktwolke liegende Werte in die Bestimmung der Extremwerte stärker einbezogen als weiter innen liegende Werte. Die Regelung reagiert also in erheblichem Umfang nicht auf die Verzerrungen allein, sondern auf die den Verzerrungen überlagerten Störgrößen, so daß insbesondere bei kleinen Signalamplituden keine geeigneten Regelgrößen zum Ausgleich der Verzerrungen abgeleitet werden könnten.

Aufgabe der Erfindung war es, einen Homodynempfänger und ein Verfahren zur Korrektur des konvertierten Empfangssignals anzugeben, mit dem eine weitgehende Korrektur der wesentlichen Fehler DC-offset, Amplituden- und Phasenfehler weitestgehend erfolgen kann.

Die Aufgabe wird durch den Empfänger nach Anpruch 1 und das Verfahren nach Anspruch 5 gelöst.

Bei einer fehlerfreien Umsetzung eines winkelmodulierten Signals sind die orthogonalen Basisbandsignale (I, Q) die orthogonalen Komponenten eines Vektors mit konstantem Betrag, der durch das modulierende Signal um den Ursprung gedreht wird. Dabei läuft die Spitze dieses Vektors auf einem Kreis um den Ursprung.

Die genannten Fehler führen zu einer Verzerrung des Kreises zu einer Ellipse. Der Amplitudenfehler bewirkt eine Stauchung des Kreises in einer Achsenrichtung des Koordinatenkreuzes, der Phasenfehler führt zu einer Verdrehung der Achsen gegeneinander und die DC-offsets führen zur Verschiebung der Ellipse auf dem Koordinatenursprung.

Der erfindungsgemäße Homodynempfänger weist für das empfangene Signal einen Signalteiler auf, mit dem das Signal in zwei Signalzweige geführt wird. Es ist ein lokaler Oszillator mit einem direkten und einem phasenverschobenen Ausgang (90°) vorhanden. Die Ausgänge des lokalen Oszillators führen zu in den Signalzweigen angeordneten Mischern zur Erzeugung des I- bzw. Q-Signals. In den beiden Signalzweigen sind Tiefpässe zur Unterdrückung von unerwünschten Mischprodukten, Trägerresten vorgesehen. Zweckmäßigerweise werden zusätzlich Signalverstärker in den beiden Signalzweigen angeordnet. Die beiden Signalzweige werden einem Rechenwerk, vorzugsweise einem digitalen Signalprozessor (DSP), zugeführt. Zwischen den Signalverstärkern und dem DSP sind zweckmäßigerweise geeignete Analog-Digitalwandler angeordnet. Die AD-Wandlung kann aber auch im Rechenwerk selbst erfolgen.

In einem bevorzugten Rechenwerk werden die quasiorthogonalen Signale I und Q synchron abgetastet, AD-gewandelt und dann als Wertepaar zu einer anschließenden Analyse herangezogen. Die Wertepaare entsprechen Punkten auf einer Ellipse, die durch Meßfehler durch die Umsetzung und durch Störungen aus dem Übertragungskanal aufgespannt ist.

Die auf der Ellipse beziehungsweise in deren Umgebung liegenden abgetasteten I- und Q-Werte werden im Rechenwerk in entsprechende, in der Umgebung eines Kreises um den Koordinatenursprung liegende Werte umgerechnet.

Durch eine Ausgleichsrechnung, z.B. mit einer linearen Regression - I.O.KERNER "Bester Kegelschnitt durch n Punkte" ZAMM 59, 396-397 (1979), oder mit einer orthonalen Regression - G. GEISE u. I. STAMMLER "Koordinatensystem-invariante Ausgleichskegelschnitte" Beiträge zur Algebra und Geometrie 21 (1986), 125-144, werden die charakteristischen fünf Parameter zur Beschreibung der am besten passenden Ellipse oder der am besten passenden elliptischen Spirale durch fünf oder mehr gemessene und ausgewählte Punkte im Rechenwerk bestimmt.

Mit den so ermittelten Parametern werden die Werte der Fehler (Ablagen) berechnet. Es wird eine Entzerrung durch eine Rücktransformation der gemessenen Wertepaare aus der Umgebung der Ellipse in die des ursprünglichen Kreises ausgeführt. Damit sind dann die durch die Instrumentierung der Konvertierung verursachten Verzerrungen weitestgehend aufgehoben und das Signal wird zur Demodulation bereitgestellt.

Das demodulierte Signal wird dann von den Verzerrungen durch die Ablage des LO's befreit.

Bevorzugt weist der verwendete lokale Oszillator eine Frequenzablage zur Trägerfrequenz des empfangenen Signals auf. Bei bisher üblichen Empfängern wurde dies möglichst zu vermeiden versucht. Teilweise wurden sogar aufwendige Regelschleifen verwendet, um die Frequenz des lokalen Oszillators möglichst genau auf die Trägerfrequenz abzustimmen. Verglichen damit gibt diese Weiterbildung der Erfindung eine gegensätzliche Lehre. Die Frequenz des lokalen Oszillators soll sich von der Trägerfrequenz so weit unterscheiden, daß die eigentlichen DC-Anteile des konvertierten Signals in den Durchlaßbereich der Bandpässe angehoben werden. Anders ausgedrückt soll die Frequenzablage so gewählt werden, daß sie im Durchlaßbereich der Bandpässe liegt. Es kommt also nicht auf eine zufällige Abweichung der Frequenz des lokalen Oszillators von der Trägerfrequenz an, sondern die Frequenzabweichung des lokalen Oszillators von der Trägerfrequenz ist auf den unteren Durchlaßbereich der Bandpässe abgestimmt.

Durch die Frequenzablage des lokalen Oszillators wird das Spektrum des nach den Mischern vorliegenden konvertierten Signals um die Frequenzablage verschoben. Durch die erfindungsgemäße Bemessungsregel für die Frequenzablage wird der eigentliche DC-Anteil des konvertierten Signals nicht mit dem DC-offset abgetrennt. Durch die erfindungsgemäße Auswahl der Frequenz des lokalen Oszillators in Verbindung mit der so durchgeführten AC-Kopplung wird vorteilhafterweise der Dynamikbereich für den AD-Wandler eingeschränkt ohne Informationen des modulierenden Signals zu verlieren.

Durch die erfindungsgemäß eingestellte Frequenzablage des lokalen Oszillators wird bewußt eine Verzerrung des demodulierten Signals eingestellt. Auch dies führt in eine zu der bisherigen Vorgehensweise entgegengesetzte Richtung. Die durch die Frequenzablage erzeugte Verzerrung kann im Vergleich zu den übrigen Verzerrungen, die durch den Bandpaß abgetrennt sind, relativ leicht in dem Rechenwerk kompensiert werden. Durch die erfindungsgemäße Kombination einer AC-Kopplung einerseits und der bewußten Einstellung einer Frequenzablage des lokalen Oszillators andererseits werden schwer abtrennbare Verzerrungen durch eine kompensierbare Verzerrung ersetzt. Es können kostengünstige AD-Wandler mit einem Dynamikbereich verwendet werden, der an den Dynamikbereich des Nutzsignals angepaßt ist.

Grundsätzlich muß die Frequenzablage (Differenz zwischen Frequenz des lokalen Oszillators und der Trägerfrequenz) im Durchlaßbereich des Bandpasses liegen. Die Frequenzablage muß also zwischen unterer Grenzfrequenz und oberer Grenzfrequenz des Bandpasses liegen. Da mit der Frequenzablage nicht nur der DC-Anteil des Basisbandsignals angehoben wird, sondern dies für alle Frequenzen des Basisbandsignal zutrifft, muß die Frequenzablage so gewählt werden, daß auch noch die größte zu erwartende (verschobene) Frequenz des Basisbandsignals im Durchlaßbereich des Bandpasses liegt. Es ist ferner der Sperrbereich zwischen mehreren Übertragungskanälen zu beachten. Unter Annahme eines idealen Bandpasses kann die maximale Frequenzablage den halben Wert der Differenz zwischen dem Kanalmittenabstand und der genutzten Kanalbreite annehmen. Bei einem realen Bandpaß muß die Frequenzablage in Abhängigkeit von der Flankensteilheit kleiner sein. Die Flankensteilheit an der unteren Grenzfrequenz des Bandpasses bestimmt auch die minimal erforderliche Frequenzablage des lokalen Oszillators.

Der erfindungsgemäße Homodynempfänger weist ein Rechenwerk auf, das zur Kompensation der durch die konstante Frequenzablage des lokalen Oszillators von der Trägerfrequenz erzeugten Verzerrung ausgebildet ist.

Die erfindungsgemäß erzeugte Verzerrung durch die Frequenzablage ist als zusätzliche stetige Phasenänderung des modulierten Signals erkennbar. Sie bewirkt eine kontinuierliche Rotation des Basisbandvektors. Die Kompensation der durch die konstante Frequenzablage erzeugten zusätzlichen stetigen Phasenänderung kann zum Beispiel durch eine stückweise Mittelwertbildung des demodulierten Signals erfolgen. Bei einer Modulation mit digitalen Informationen kann die durch die konstante Frequenzablage erzeugte Verzerrung des demodulierten Signals als Steigung einer Ausgleichsgeraden im Phasen-Zeitdiagramm bestimmt und kompensiert werden.

Zur Kompensation der durch die Frequenzablage des LO verursachten Fehler kann aber auch eine im Empfänger als bekannt vorauszusetzende Eigenschaft des Signals gesucht und bewertet werden. Als bekannt vorauszusetzende Eigenschaft ist bei analogen Sprachsignalen seine DC-Freiheit, bei digitalen Signalen entweder die Modulationsart mit relativ stationären Aufenthalts- oder Umkehrorten des Signalvektors oder die sogenannten Trainingssequenzen, zum Beispiel bei GSM und DECT oder modulationsfreie CW-Abschnitte anzusehen. Die Entzerrung der Basisbandsignale erfolgt in der Erfindung so weitreichend, daß auf jegliche Rückführung von abgeleiteten Regelsignalen zur Kontrolle des LO's verzichtet werden kann.

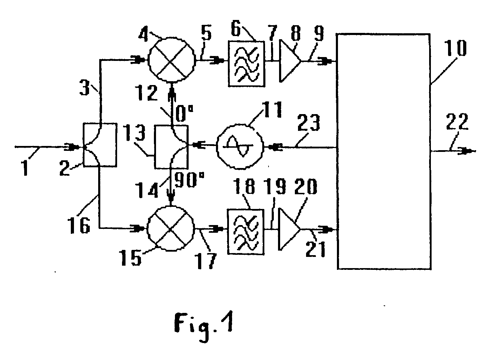

Ein Ausführungsbeispiel des erfindungsgemäßen Verfahrens wird anhand der schematischen Darstellung in Fig. 1 erläutert. Fig. 1 zeigt in schematischer Darstellung ein Blockschaltbild eines Homodynempfängers mit nachgeschaltetem Rechenwerk.

Über die Leitung 1 wird das empfangene Signal einem Signalteiler 2 zugeführt. In dem Signalteiler 2 wird das empfangene Signal in einen ersten Anteil und einen zweiten Anteil aufgeteilt. Der erste Anteil wird über die Leitung 3 einem Mischer 4 zugeführt. In dem Mischer 4 wird der erste Signalteil mit dem am direkten Ausgang 12 des lokalen Oszillators 11 anliegenden Signal gemischt. Hierdurch entsteht im Mischer 4 das In-phase-Signal (I). Dieses Signal wird über die Leitung 5 dem Bandpaß 6 zugeführt. Dort werden unerwünschte Mischprodukte, Trägerfrequenzreste, aber auch DC-offsets abgetrennt. Das gefilterte Signal wird über die Leitung 7 einem Signalverstärker 8 zugeführt. Das verstärkte Signal wird über die Leitung 9, gegebenenfalls nach Zwischenschaltung eines AD-Wandlers, dem Rechenwerk 10 zugeführt. Der zweite im Signalteiler 2 erzeugte Signalteil wird über die Leitung 16 dem Mischer 15 zugeführt. Im Mischer 15 wird das am Ausgang 13 des lokalen Oszillators 11 anliegende, über die Leitung 14 zugeführte, um 90° phasenverschobene Signal des lokalen Oszillators 11 mit dem zweiten, über die Leitung 16 zugeführten Signalteil gemischt. Das Mischprodukt, das als Quadratursignal (Q) bezeichnet wird, wird über die Leitung 17 dem Bandpaß 18 zugeführt. Die Funktion des Bandpasses 18 entspricht derjenigen des oben beschriebenen Bandpasses 6. Das gefilterte Q-Signal wird über die Leitung 19 einem Signalverstärker 20 zugeleitet. Hiervon wird es gegebenenfalls nach einer nicht dargestellten Analog-Digitalwandlung mit der Leitung 21 in das Rechenwerk 10 geführt. Dort erfolgt die Umrechnung der in der Umgebung der Ellipse liegenden I- und Q-Werte auf die in der Umgebung eines im Koordinatenursprung angeordneten Kreises liegenden Werte.

Dazu werden zunächst in einer Ausgleichsrechnung die Parameter der Ellipse bestimmt. Danach werden aus der parametrisierten Ellipse die die Ellipse verursachenden Fehler berechnet. Anschließend werden in den verzerrten I- und Q-Signalen die ermittelten Fehler kompensiert.

Im Rechenwerk 10 wird auch die Demodulation mittels der I- und Q-Signale durchgeführt. Hier entsteht ansich das demodulierte Signal, dies ist jedoch noch wegen der erfindungsgemäß vorgesehenen Frequenzablage des lokalen Oszillators verzerrt. Die Verzerrung ist im Phasen-Zeitdiagramm zum Beispiel, wenn das modulierende Signal Sprache ist, als stetiger überlagerter Anstieg im Phasen-Zeitdiagram erkennbar. Dieser stetige Anstieg wird im Rechenwerk durch stückweise Mittelwertbildung bestimmt und kann dann kompensiert (subtrahiert) werden. Mit der Leitung 22 wird das demodulierte, entzerrte Signal zu weiteren Baugruppen geführt.

In einer besonderen Ausführung kann vorgesehen sein, daß der lokale Oszillator 11 regelbar ist, um "spread spectrum" Anwendungen zu ermöglichen. Hierfür kann eine Steuerleitung 23 vom Rechenwerk 10 zum lokalen Oszillator 11 führen. Auch hierbei bleibt die erfindungsgemäße vorgesehene Frequenzablage erhalten.

## Patentansprüche

1. Homodynempfänger mit einem Signalteiler (2), einem lokalen Oszillator (11) mit einem direkten (12) und einem phasenverschobenen (14) Ausgang, mit zwei Mischern (4, 15) zur Erzeugung von I- und Q-Signal, zwei Bandpässen (6, 18) zur Unterdrückung von unerwünschten Mischprodukten und Trägerresten und DC-offsets, zwei Signalverstärker (8, 20) und einem Rechenwerk (10) zur Entzerrung, welches zur Umrechnung der von den verzerrten I- und Q-Signalen aufgespannten Ellipse in einen Kreis ausgebildet ist, dadurch gekennzeichnet, daß das Rechenwerk (10) zur Bestimmung der Ellipsenparameter mittels einer Ausgleichsrechnung über mindestens 5 abgetastete Werte der I- und Q-Signale ausgebildet ist.

2. Homodynempfänger nach Anspruch 1, dadurch gekennzeichnet, daß das Rechenwerk (10) zur Bestimmung der die Ellipsenform hervorrufenden Fehler aus den ermittelten Ellipsenparametern ausgebildet ist.

3. Homdynempfänger nach Anspruch 2, dadurch gekennzeichnet, daß das Rechenwerk (10) zur Kompensation der die Ellipse hervorrufenden Fehler ausgebildet ist.

4. Homodynempfänger nach einem der Ansprüche 1 bis 3, dadurch gekennzeichnet, daß der lokale Oszillator (11) eine definierte Frequenzablage zur Trägerfrequenz aufweist, so daß die Differenzfrequenz zwischen Trägerfrequenz und Oszillatorfrequenz im Durchlaßbereich der Bandpässe liegt.

5. Verfahren zur direkten Konvertierung und Korrektur des konvertierten Empfangssignals eines Homodynempfängers durch Aufteilung des empfangenen Signals in zwei Signalzweige (3, 16), Mischung (4) des ersten Signalzweiges (3) mit dem Signal (12) eines lokalen Oszillators, Mischung des zweiten Signalzweiges (16) mit dem um 90° verschobenen Signal (14) eines lokalen Oszillators (11), Bandpaßfilterung (6, 18), Verstärkung (8, 20), AD-Wandlung und Demodulation sowie Entzerrung in einem Rechenwerk (10), in dem die Umrechnung der von den verzerrten I- und Q-Signalen augespannten Ellipse in einen Kreis im Ursprung erfolgt, dadurch gekennzeichnet, daß im Rechenwerk (10) die Parameter einer Ausgleichsellipse durch mindestens 5 abgetastete Werte der I- und Q-Signale bestimmt werden.

6. Verfahren nach Anspruch 5, dadurch gekennzeichnet, daß aus den Ellipsenparametern die die Ellipse verursachenden Fehler bestimmt werden.

7. Verfahren nach Anspruch 6, dadurch gekennzeichnet, daß in den verzerrten I- und Q-Signalen die Fehler kompensiert werden.

8. Verfahren nach Anspruch 7, dadurch gekennzeichnet, daß die I- und Q-Signale demoduliert werden, die stetige Phasenänderung durch stückweise Mittelwertbildung oder durch Bestimmung der Steigung einer Ausgleichsgeraden im Phasen-Zeitdiagramm bestimmt und kompensiert wird.

## Claims

1. Direct conversion receiver comprising a signal splitter (2), a local oscillator (11) having a direct (12) and a phase-shifted (14) output, comprising two mixers (4, 15) for generating an I-signal and a Q-signal, two band-pass filters (6, 18) for suppressing undesirable mixing products and carrier residues and DC offsets, two signal amplifiers (8, 20) and a correcting arithmetic unit (10) which is designed to convert the ellipse generated by the distorted I- and Q-signals into a circle, characterized in that the arithmetic unit (10) is designed to determine the ellipse parameters by means of a regression calculation using at least 5 sampled values of the I- and Q-signals.

2. Direct conversion receiver according to Claim 1, characterized in that the arithmetic unit (10) is designed to determine the errors producing the ellipse shape from the ellipse parameters found.

3. Direct conversion receiver according to Claim 2, characterized in that the arithmetic unit (10) is designed to compensate for the errors producing the ellipse.

4. Direct conversion receiver according to one of Claims 1 to 3, characterized in that the local oscillator (11) has a defined frequency departure with respect to the carrier frequency so that the differential frequency between carrier frequency and oscillator frequency is in the transmission range of the band-pass filter.

5. Method for the direct conversion and correction of converted reception signals of a direct conversion receiver by dividing the received signal into two signal branches (3, 16), mixing (4) the first signal branch (3) with the signal (12) of a local oscillator, mixing the second signal branch (16) with the 90°-shifted signal (14) of a local oscillator (11), band-pass filtering (6, 18), amplification (8, 20), A/D conversion and demodulation and also correction in an arithmetic unit (10) in which the ellipse generated by the distorted I- and Q-signals is converted into a circle at the origin, characterized in that, in the arithmetic unit (10), the parameters of a regression ellipse are determined by at least 5 sampled values of the I- and Q-signals.

6. Method according to Claim 5, characterized in that the errors producing the ellipse are determined from the ellipse parameters.

7. Method according to Claim 6, characterized in that the errors are compensated for in the distorted I- and Q-signals.

8. Method according to Claim 7, characterized in that the I- and Q-signals are demodulated and the constant phase change is determined and compensated for by section-by-section averaging or by determining the slope of a regression line in the phase/time diagram.

## Revendications

1. Récepteur homodyne comprenant un séparateur de signal (2), un oscillateur local (11) avec une sortie directe (12) et une sortie déphasée (14), deux étages mélangeurs (4, 15) générateurs des signaux I et Q, deux filtres passe-bande (6, 18) de suppression des produits de mélange indésirables, reliquats de porteuse et des seuils DC, deux amplificateurs de signal (8, 20) et d'une unité de calcul (10) d'annulation de la distorsion, conçue pour convertir par calcul, l'ellipse, formée par les signaux distordus I et Q, en cercle, caractérisé par le fait, que l'unité de calcul (10) détermine par un calcul de compensation, les paramètres de l'ellipse à l'aide d'au moins 5 échantillons des signaux I et Q.

2. Récepteur homodyne selon la revendication 1, caractérisé par le fait que l'unité de calcul (10) est conçue pour déterminer les erreurs responsables de la forme elliptique partant des paramètres d'ellipse obtenus.

3. Récepteur homodyne selon la revendication 2, caractérisé par le fait que l'unité de calcul (10) est conçue pour compenser les erreurs responsables de l'ellipse.

4. Récepteur homodyne selon une des revendications 1 à 3, caractérisé par le fait que la fréquence de l'oscillateur local (11) est décalée d'un écart défini de la fréquence porteuse, de sorte que la fréquence de différence entre la fréquence de la porteuse et la fréquence de l'oscillateur est située dans la bande de passage des filtres passe-bande.

5. Procédé de conversion directe et de correction du signal capté converti d'un récepteur homodyne par partage du signal capté en deux voies de signal (3, 16), mélange (4) du signal de la première voie (3) avec le signal (12) d'un oscillateur local, mélange de la fréquence de la deuxième voie (16) avec le signal d'un oscillateur local déphasé de 90° (14), filtrage par passe-bande (6, 18), amplification (8, 20), conversion a/n et démodulation ainsi que l'annulation de la distorsion dans une unité de calcul (10), qui, par calcul; transforme l'ellipse, produite par la distorsion des signaux I et Q, en cercle sur l'origine, caractérisé par la détermination par l'unité de calcul (10) des paramètres d'une ellipse de compensation à l'aide d'au moins 5 échantillons des signaux I et Q.

6. Procédé selon la revendication 5, caractérisé par la détermination des erreurs responsables de l'ellipse partant des paramètres de l'ellipse.

7. Procédé selon la revendication 6, caractérisé par la compensation des erreurs des signaux I et Q distordus.

8. Procédé selon la revendication 7, caractérisé par la démodulation des signaux I et Q, par la détermination par sections de la valeur moyenne de la variation continue de phase ou par la détermination dans le diagramme phase-temps de la pente de compensation et compensation.
